# EUROPÄISCHE PATENTSCHRIFT

(11) **EP 2 865 068 B1**
(45) Veröffentlichungstag und Bekanntmachung des Hinweises auf die Patenterteilung: **09.08.2017**
(21) Anmeldenummer: 13730860.7
(22) Anmeldetag: 17.06.2013
(51) Int. Cl.: H02J 7/00, B60L 3/00, G01R 31/36, H01M 2/20

(54) **BATTERIEMANAGEMENTSYSTEM MIT ERHÖHTER ROBUSTHEIT GEGENÜBER NEGATIVEN SPANNUNGEN**
BATTERYMANAGEMENTSYSTEM WITH IMPROVED ROBUSTNESS AGAINST NEGATIVE VOLTAGES
SYSTÈME DE GESTION DE BATTERIE POUR AMÉLIORER LA ROBUSTESSE AUX EXCURSIONS DE TENSION NEGATIVE

(30) Priorität: 22.06.2012 DE 102012210616
(43) Veröffentlichungstag der Anmeldung: 29.04.2015
(73) Patentinhaber: Robert Bosch GmbH, 70442 Stuttgart (DE); Samsung SDI Co., Ltd., Yongin-si, Gyeonggi-do 446-577 (KR)
(72) Erfinder: FINK, Holger, 70567 Stuttgart (DE)
(74) Vertreter: Bee, Joachim
(86) Internationale Anmeldenummer: PCT/EP2013/062477
(87) Internationale Veröffentlichungsnummer: WO 2013/189870

(56) Entgegenhaltungen:
- EP-A1- 2 385 604
- WO-A1-93/10589
- US-A1- 2005 017 682
- US-A1- 2010 072 950
- US-B1- 7 433 794

## Beschreibung

Die vorliegende Erfindung betrifft ein Batteriemanagementsystem mit mindestens einer Zellüberwachungseinheit, die mehrere Zellspannungsanschlüsse, mit den Zellspannungsanschlüssen gekoppelte Zuführungsleitungen, und eine Zellüberwachungsschaltung aus mehreren elektronischen Halbleitermodulen, die mittels der Zuführungsleitungen parallel geschaltet sind, umfasst. Insbesondere betrifft die Erfindung ein derartiges Batteriemanagementsystem, das dazu vorgesehen ist, mittels der mindestens einen Zellüberwachungseinheit eine Vielzahl von Batteriezellen zu überwachen, die jeweils beidseitig, mit ihrem jeweiligen positiven Batteriezellenterminal und ihrem negativen Batteriezellenterminal über die Zellspannungsanschlüsse mit dem Batteriemanagementsystem verbunden sind,

### Stand der Technik

Es zeichnet sich ab, dass in Zukunft sowohl bei stationären Anwendungen, wie zum Beispiel Windkraftanlagen, in Fahrzeugen, wie zum Beispiel in Hybrid- und Elektrofahrzeugen, als auch im Consumer-Bereich, wie zum Beispiel bei Laptops und Mobiltelefonen, vermehrt neue Batteriesysteme zum Einsatz kommen werden, an die sehr hohe Anforderungen bezüglich deren Zuverlässigkeit, Sicherheit, Leistungsfähigkeit und Lebensdauer gestellt werden.

Für solche Aufgaben sind insbesondere Batterien mit Lithium-Longen-Technologie geeignet. Sie zeichnen sich unter anderem durch hohe Energiedichte und eine geringe Selbstentladung aus. Definitionsgemäß bestehen Lithium-Ionen-Batterien aus zwei oder mehr Lithium-Ionen-Zellen, die miteinander verschaltet sind. Lithium-Ionen-Zellen können durch parallele oder serielle Verschaltung zu Modulen, und dann zu Batterien verschaltet werden. Ein Batteriemodul besteht dabei typischerweise aus sechs oder mehr Zellen.

Zur Gewährleistung einer sicheren und ordnungsgemäßen Funktion einer ausreichend langen Lebensdauer können Lithium-Ionen-Zellen mit einem Batteriemanagementsystem verbunden werden, mit dem eine Überwachung und Regelung der Batterie erfolgt. Dabei führt das Batteriemanagementsystem eine Vielzahl von Aufgaben, wie Balancing, Temperaturregelung, usw. an den Batteriezellen durch, die für den Betrieb der Batteriezellen benötigt werden. Insbesondere erfolgt auch eine Überwachung der elektrischen Spannung der einzelnen Batteriezellen, insbesondere damit keine Überladung oder Unterladung stattfindet.

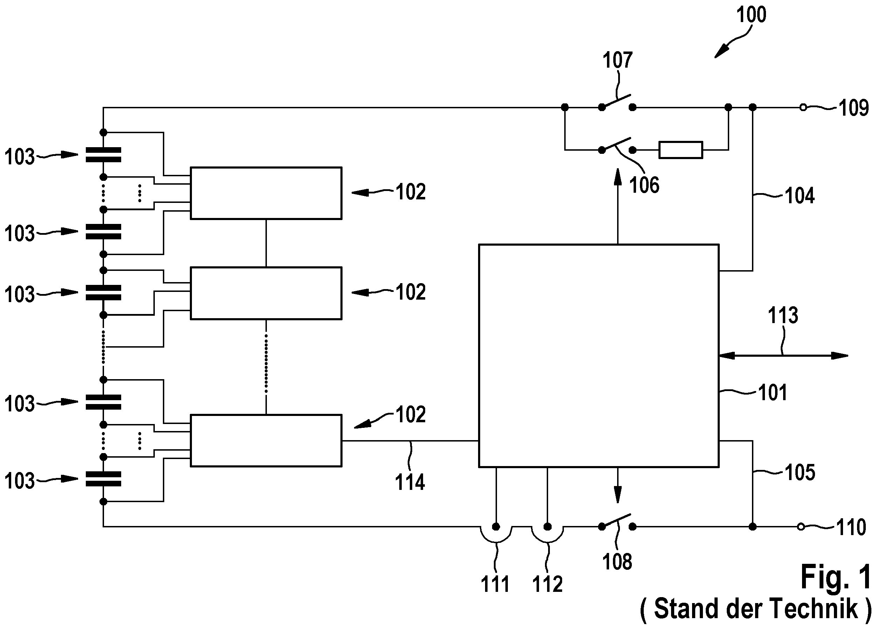

Das Prinzipschaltbild eines Batteriemanagementsystems 100 einer Traktionsbatterie ist in Figur 1 dargestellt. Die dort gezeigte Architektur besteht aus einer sogenannten Batteriesteuerungseinheit 101 ("Battery Control Unit") (BCU) und mindestens einer oder mehreren, über einen Kommunikationsbus 114 vor Ort an den Batteriemodulen (nicht gekennzeichnet) angeschlossenen, sogenannten Zellüberwachungseinheiten 102 ("Cell Supervision Circuits") (CSC). Dabei überwacht eine Zellüberwachungseinheit 102 die Batteriezellen 103 von beispielsweise einem oder zwei Batteriemodulen. Die Zellüberwachungseinheiten 102 sind in hinreichender Anzahl vorhanden, um die hohe Zahl, beispielsweise bis zu einhundert, von Batteriezellen 103 einer Traktionsbatterie zu überwachen. Je nachdem, welche Anforderungen an die Leistungsfähigkeit des Batteriesystems gestellt werden, können die BCU- und die CSC-Elektroniken auch auf einer gemeinsamen Leiterplatte angeordnet sein. Wie in der Figur 1 außerdem gezeigt, wird die Gesamtspannung der Batterie mittels einer positiven Batteriespannungszuführungsleitung 104 und einer negativen Batteriespannungszuführungsleitung 105 von der Batteriesteuerungseinheit abgegriffen, um dann in der Batteriesteuerungseinheit weiter verarbeitet zu werden. Ferner steuert die Batteriesteuerungseinheit 101, neben einem Ladeschütz 106, auch ein positives Batterieschütz 107 und ein negatives Batterieschütz 108 an, mittels denen das positive Batteriezellenterminal 109 und das negative Batteriezellenterminal 110 jeweils spannungslos geschaltet werden können. Insbesondere kann durch eine Ansteuerung und ein daraufhin folgendes Öffnen der Schütze eine Abtrennung der Batterie im Falle eines Überstromes oder eines Kurzschlusses erreicht werden, wodurch im Notfall eine durch die hohe Batteriespannung verursachte Gefahrensituation abgewendet werden kann. Zur Ermittlung des Batteriestroms dienen Stromsensoren 111, 112. Ferner kann die Batteriesteuerungseinheit 101 beispielsweise mittels eines CAN-Busses 113 mit einem zentralen Fahrzeugsteuerungsgerät (nicht gezeigt) verbunden sein.

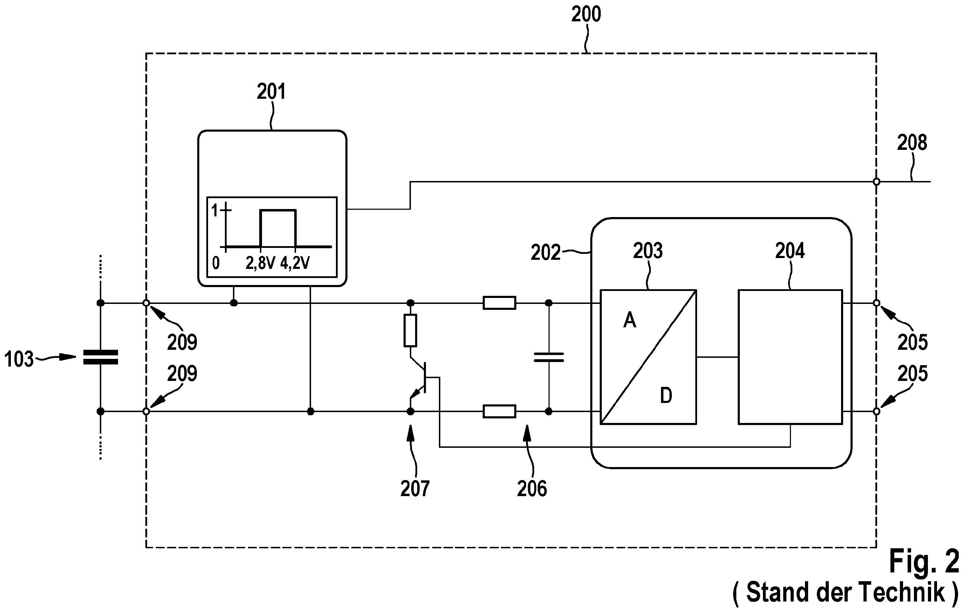

In Figur 2 ist eine Prinzipdarstellung einer beispielhaften Eingangsschaltung einer Zellüberwachungseinheit 200 dargestellt. Wie in Figur 2 gezeigt wird, ist die Zellüberwachungseinheit 200 modular aufgebaut und weist einen als Begleitchip 201 ("companion chip") bezeichneten Überwachungsbaustein auf, welcher die Einhaltung des zulässigen Zellspannungsbereichs kontrolliert, sowie einen sogenannten Front-End-Chip beziehungsweise Hauptchip 202, mit dem die Zellspannungen gemessen werden. Der Front-End-Chip 202 umfasst einen Analog-Digital-Wandler 203 und eine Steuerungs- und Kommunikationseinheit 204, die beispielsweise über Daisy-Chain-Anschlüsse 205 Daten ausgeben und einlesen kann. Ferner weist die Eingangsschaltung der Zellüberwachungseinheit 200 einen Filter 206 und eine resistiv arbeitende Balancingschaltung 207 auf. Der Begleitchip 201 kann als ein Schwellenspannungs-Komparator ausgebildet sein und bei Überschreiten beziehungsweise Unterschreiten von jeweiligen Spannungsgrenzen einen Alarm 208 ausgeben und eine Hardware-Reißleine betätigen, beispielsweise um die in Figur 1 gezeigten Schütze zu öffnen. Wie in Figur 2 gezeigt, können die Spannungsgrenzen bei Lithium-Ionen-Zellen 2,6 V beziehungsweise 4,2 V betragen. Die Zellspannung wird als eine Eingangsspannung an den Zellspannungsanschlüssen 209 ermittelt.

Eine Zellüberwachungseinheit, die einen Begleitchip aufweist, wird beispielsweise in einer früheren Patentanmeldung der Anmelderin mit der Anmeldenummer DE 10 2011 079 120 A1 beschrieben.

Nachteilig an den bekannten Batteriemanagementsystemen ist, dass eine Überwachung, welche auch negative Eingangsspannungen mit einschließt, insbesondere bei Vorhandensein von vielen zu überwachenden Batteriezellen, einen hohen zusätzlichen Schaltungsaufwand erfordern würde, was mit hohen Kosten verbunden wäre. Aus diesem Grund sind die bekannten Batteriemanagementsysteme oft nicht ausreichend robust gegen negative Eingangsspannungen ausgestaltet.

Die US 2005/0017682 A1 offenbart ein autonomes Zell-Balancing-System mit einer Vielzahl an Batteriezellen, welche über Zuführungsleitungen mit Zellüberwachungsschaltungen verbunden sind. In jeder der Zuführungsleitungen ist eine Schmelzsicherung vorgesehen.

US 2010/0072950 A1 offenbart ein Batteriesystem mit einer Vielzahl an in Serie geschalteten Batteriemodulen und mit mehreren Überwachungsmodulen, welche zu einer Überwachung der Spannung der einzelnen Zellen der Batteriemodule ausgebildet sind.

In der EP 2 385 604 A1 ist ein Verfahren zur Überwachung eines Akkumulators mit mehreren Zellen beschrieben, bei dem ein Parameter einer Zelle gemessen und an eine zentrale Überwachungseinheit übermittelt wird. Die Übermittlung von Messwerten erfolgt mit Hilfe eines pulsweitenmodulierten Signals.

In der WO 93/10589 wird eine Vorrichtung zur Balancierung des Ladungszustandes einer Vielzahl von in Reihe geschalteten Batteriezellen offenbart, wobei die Vorrichtung ferner Mittel zur Überwachung des Ladezustandes der Batteriezellen aufweist.

Des Weiteren wird in der US 7,433,794 B1 ein Verfahren zur Abschwächung der Ausbreitung von Wärme in einem Energiespeichersystem bereitgestellt, wobei das Energiespeichersystem eine Vielzahl von Zellen aufweist. Das Verfahren ermöglicht die Kontrolle der Temperatur des Energiespeichersystems als auch von der Temperatur der Zellen des Energiespeichersystems.

### Offenbarung der Erfindung

Erfindungsgemäß wird ein Batteriemanagementsystem mit mindestens einer Zellüberwachungseinheit zur Verfügung gestellt, die mehrere Zellspannungsanschlüsse, mit den Zellspannungsanschlüssen gekoppelte Zuführungsleitungen, und eine Zellüberwachungsschaltung aus mehreren elektronischen Halbleitermodulen aufweist. Dabei sind die elektronischen Halbleitermodule mittels der in der mindestens einen Zellüberwachungseinheit angeordneten Zuführungsleitungen parallel geschaltet. Die mindestens eine Zellüberwachungseinheit ist dazu ausgebildt, eine Vielzahl von Batteriezellen zu überwachen, die jeweils beidseitig, mit ihrem jeweiligen positiven Batteriezellenterminal und ihrem negativen Batteriezellenterminal über die Zellspannungsanschlüsse mit der Zellüberwachungseinheit verbunden sind. Ferner sind eine oder mehrere der Zuführungsleitungen mit einer Schmelzsicherung versehen, wobei je Batteriezelle zumindest eine der mit dieser gekoppelten Zuführungsleitung eine Schmelzsicherung in ihrem Strompfad aufweist, wobei die Zuführungsleitungen jeweils entweder einen positiven Zweig zum Kontaktieren mit einem positiven Batteriezellenterminal oder einen negativen Zweig zum Kontaktieren mit einem negativen Batteriezellenterminal bilden, wobei die Schmelzsicherungen bezogen auf eine Reihenfolge, die durch eine Anordnung der Zellspannungsanschlüsse in einer Richtung entlang eines Stranges aus Batteriezellen gegeben ist, wechselweise in einem positiven Zweig oder einem negativen Zweig der Zuführungsleitungen platziert sind.

Ein Vorteil der Erfindung ist, dass eine erhöhte Robustheit des Batteriemanagementsystems auch gegen negative Eingangsspannungen an den Zellspannungsanschlüssen bereitgestellt werden kann. Insbesondere kann verhindert werden, dass aufgrund von negativen Eingangsspannungen eine Zerstörung der integrierten Schaltkreise beziehungsweise der elektronischen Halbleitermodule, die in dem Batteriemanagementsystem beziehungsweise den Zellspannungsüberwachungseinheiten angeordnet sind, stattfindet. Hintergrund für die Schädigung ist, dass die Halbleiterbausteine empfindlich gegenüber negativen Spannungen an ihren Eingängen sind und dass als Folge solcher negativer Spannungen sehr hohe Inversströme durch die Bausteine fließen können. Solche hohen Inversströme können neben einer Zerstörung der Halbleiterbausteine auch zu einem Brand des Leiterplattenmaterials der Zellspannungsüberwachungseinheiten führen, was wiederum einen Fahrzeugbrand zur Folge haben kann. Erfindungsgemäß wird das Batteriemanagementsystem durch die in den Zellüberwachungseinheiten angeordneten Schmelzsicherungen bei negativen Eingangsspannungen geschützt. Eine diesbezüglich eventuell vorgesehene Erweiterung der Überwachungselektronik hinsichtlich von negativen Spannungen wird überflüssig.

Gemäß einer Ausführungsform der Erfindung weisen die elektronischen Halbleitermodule einen Begleitchip ("companion chip"), der die Einhaltung des zulässigen Zellspannungsbereichs kontrolliert, und einen Hauptchip, der auch als Front-End-Chip bezeichnet wird, auf. Der Hauptchip kann einen Analog-Digital-Wandler und eine Steuerungs- und Kommunikationseinheit umfassen. Mittels des Hauptchips können die Zellspannungen gemessen werden.

Die Halbleiterbauelemente des Begleitchips werden erfindungsgemäß durch die Schmelzsicherungen, welche in einer oder mehreren der Zuführungsleitungen vorgesehen sind, geschützt. Die erfindungsgemäße Lösung ist nicht auf derartige Batteriemanagementsysteme beschränkt, die nur auf Halbleiterbauelemente basieren. So wird der Begriff "Halbleitermodul" im Rahmen dieser Erfindung allgemein für einen Baustein verwendet, der Halbleiterbauelemente aufweist oder dessen Funktionalität hauptsächlich oder zum großen Teil auf Hauptleiterbauelementen basiert, wobei auch Bauelemente vorhanden sein können.

Bei einer vorteilhaften Ausführungsform der Erfindung bilden die Zuführungsleitungen jeweils entweder einen High-Side-Pfad zum Kontaktieren mit einem positiven Batteriezellenterminal oder einen Low-Side-Pfad zum Kontaktieren mit einem negativen Batteriezellenterminal, wobei die erfindungsgemäß eingesetzten Schmelzsicherungen bezogen auf eine Reihenfolge, die durch eine Anordnung der Zellspannungsanschlüsse entlang eines Stranges aus Batteriezellen gegeben ist, wechselweise in einem positiven Zweig oder einem negativen Zweig der Zuführungsleitungen platziert werden.

Dadurch kann auf besonders kostengünstige Weise bereits ein erhöhter Schutz des Batteriemanagementsystems vor negativen Strömen oder in inverser Richtung fließenden Überströmen erreicht werden. Dabei wird im Vergleich zur Gesamtanzahl der Zellspannungsanschlüsse beziehungsweise der Zuführungsleistungen nur die halbe Anzahl von den erfindungsgemäßen Schmelzsicherungen verbaut.

So kann bei dieser Ausführungsform insbesondere bereits ein wirksamer Schutz vor Überstrom bei solchen Ereignissen zur Verfügung gestellt werden, bei denen eine negative Spannung so anliegt, dass ein oberer und ein unterer Angriffspunkt der negativen Spannung jeweils über eine Sicherung angebunden sind, wobei ein Zellspannungsanschluss, der zwischen den Angriffspunkten liegt, lediglich mit einer ungesicherten Leitung verbunden ist.

Dabei eignet sich diese Ausführungsform für Batterien, bei denen aufgrund der speziellen Bauart der Batterie und der Batteriezellen negative Spannungen lediglich mit einer verringerten Wahrscheinlichkeit zwischen zwei derartigen Zellspannungsanschlüssen auftreten, bei denen keine der Zuführungsleitungen mit einer erfindungsgemäßen Schmelzsicherung versehen ist, und bei denen eine vorliegende negative Spannung stattdessen mit erhöhter Wahrscheinlichkeit vornehmlich zwischen zwei derartigen Zuführungsleitungen anliegt, von denen mindestens eine mit einer erfindungsgemäßen Schmelzsicherung versehen ist. Anschaulich gesagt, die vorteilhafte kostengünstige Ausführungsform eignet sich beispielsweise für Batterien, bei denen typischerweise eine vorliegende negative Spannung nicht zwischen zwei ungesicherten Zellspannungsanschlüssen beziehungsweise Kanälen stattfindet, so dass lediglich in der Mitte dieser beiden Kanäle sich eine abgesicherte Zuführungsleitung befindet. In einem solchen Fall läge die negative Eingangsspannung, auch wenn die Sicherung ausgelöst wurde, noch über die beiden ungesicherten Kanale am Batteriemanagementsystem an und kann entsprechend negative Auswirkungen haben.

Somit kann die oben genannte Ausführungsform mit halbem potentiellen Aufwand genau solche Fälle abdecken, die in der Praxis mit hoher Wahrscheinlichkeit auftreten.

Die Erfindung ist insbesondere auch für solche Zellüberwachungseinrichtungen ausgelegt, die einen Filter und eine Balancingschaltung aufweisen, welche mit den Zuführungsleitungen der Zellüberwachungs-Elektroniken verbunden sind, genauer gesagt, bei denen der Filter und die Balancingschaltung zu den restlichen von den erfindungsgemäßen elektronischen Halbleitermodulen mittels der Zuführungsleitungen parallel geschaltet sind.

Ferner ist die Erfindung auch vorteilhaft anwendbar bei Batteriemanagementsystemen, bei denen sogenannte Senseleitungen für eine hochgenaue Spannungserfassung eingesetzt werden.

So ist gemäß einer vorteilhaften Ausführungsform der Erfindung zumindest eine der Zellüberwachungseinheiten derart ausgestaltet, dass ihre Zuführungsleitungen als mit den entsprechenden zugeordneten Zellspannungsanschlüssen gekoppelte Senseleitungen ausgebildet sind. Dabei weisen die elektronischen Halbleitermodule der zumindest einen Zellüberwachungseinheit zumindest eine Balancingschaltung auf, wobei die Balancingschaltung direkt an die Zellspannungsanschlüsse gekoppelt ist. Die Balancingschaltung ist zwischen den Zellspannungsanschlüssen und den restlichen Halbleitermodulen, insbesondere einer Schaltung zur Ermittlung von Zellspannungen angeordnet. Genauer gesagt, es wird bevorzugt, dass zwischen der Balancingschaltung und jenjenigen Zellspannungsanschlüssen, an welche die Balancingschaltung ankoppelt, keine weiteren Halbleitermodule angeordnet sind. Mit anderen Worten, es wird bevorzugt, dass die restlichen Halbleitermodule, inklusive einer Schaltung zur Ermittlung einer Zellspannung derjenigen Batteriezelle, welche mit der Balancingschaltung balanciert wird, hinter der Balancingschaltung angeordnet.

Dadurch kann günstigerweise die Länge des Strompfads eines Balancingstroms minimiert werden, so dass quasi kein durch den Balancingstrom verursachter Spannungsabfall stattfindet, der eine Spannungsmessung verfälscht. Somit eignet sich diese Ausführungsform besonders zur hochgenauen Ermittlung von Zellspannungen.

Gemäß dieser Ausführungsform werden beispielsweise der Begleitchip und ein Filter derart angeschlossen, dass sie sich zwischen der Balancingschaltung und der Zellspannungsermittlungsschaltung befinden.

Besonders bevorzugt wird außerdem, dass die erfindungsgemäße Schmelzsicherung, oder wenn sowohl ein jeweiliger positiver Zweig als auch ein jeweiliger negativer Zweig mit einer eigenen Schmelzsicherung versehen sind, die jeweiligen beiden Schmelzsicherungen zwischen der Balancingschaltung und der Zellspannungsermittlungsschaltung in den Zuführungsleitungen, hier den Senseleitungen, angeordnet sind.

Die Zellspannungsermittlungsschaltung kann durch den Hauptchip beziehungsweise den Front-End-Chip implementiert sein, der mittels der Senseleitungen eine aktuelle Batteriezellenspannung an den Zellspannungsanschlüssen abgreift. Wie oben bereits erwähnt, wird dann die Balancingschaltung bevorzugt ebenfalls mit den Senseleitungen verbunden, direkt unmittelbar hinter den Zellspannungsanschlüssen.

Gemäß einer sehr vorteilhaften Weiterbildung der Erfindung weist die Balancingschaltung einen MOSFET-Schalter, einen Balancingwiderstand und eine invers zu einer normalen Batteriezellenspannung gepolte Intrinsic-Diode auf. Dadurch kann, obgleich die Schmelzsicherung nicht vor der Balancingschaltung, sondern lediglich dahinter angeordnet ist, auch für den Fall, dass Senseleitungen verwendet werden, für die Balancingschaltung ein ausreichender Schutz gegen negativen Strom bereitgestellt werden.

Gemäß einem Aspekt der Erfindung wird ferner eine Batterie mit einem oder mehreren Batteriemodulen zur Verfügung gestellt, die ferner das erfindungsgemäße Batteriemanagementsystem aufweist. Die Batterie umfasst eine Vielzahl von Batteriezellen, die in einen oder mehreren Batteriesträngen angeordnet sind, wobei ein Batteriestrang eine Vielzahl von in Reihe geschalteten Batteriezellen aufweist, so dass eine hohe Ausgangsspannung erzeugt werden kann, beispielsweise um ein Kraftfahrzeug anzutreiben.

Nach einer Weiterbildung der Erfindung wird die Robustheit der Batterie weiterhin erhöht, indem zum Schutz der Batteriezellen vor Überstrom eine oder mehrere der in Reihe geschalteten Batteriezellen jeweils eine integrierte Zellsicherung aufweisen. Die integrierte Zellsicherung ist derart gestaltet, dass bei einem Überstrom der Stromfluss doch die Batteriezelle unterbrochen wird. Dadurch können Schädigungen der Batteriezellen beispielsweise bei Auftreten eines Kurzschlusses vermieden werden.

Gleichzeitig kann durch die in den Zellüberwachungseinheiten angeordneten Schmelzsicherungen sichergestellt werden, dass durch eine solche Trennung einer Batteriezelle von dem Batteriestrang, obgleich in einem solchen Fall eine hohe negative Spannung an den entsprechenden Zellspannungsanschlüssen entsteht, kein Schaden in der Zellüberwachungseinheit verursacht wird.

Bevorzugt ist die erfindungsgemäße Batterie eine Lithium-Ionen-Batterie.

Ferner wird erfindungsgemäß ein Kraftfahrzeug mit einem Elektromotor zur Verfügung gestellt, das die erfindungsgemäße Batterie umfasst, wobei die Batterie den Elektromotor versorgt und in einem Antriebsstrang des Kraftfahrzeugs angeordnet ist.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 ein Prinzipschaltbild eines Batteriemanagementsystems für Traktionsbatterien gemäß dem Stand der Technik,
Figur 2 eine Prinzipdarstellung der Eingangsschaltung einer beispielhaften Zellüberwachungseinheit gemäß dem Stand der Technik,
Figur 3 eine mit einer integrierten Sicherung versehene Batteriezelle, die mit dem erfindungsgemäßen Batteriemanagementsystem überwacht und geregelt werden kann, gemäß einer Ausführungsform der Erfindung,
Figur 4 eine Darstellung einer erfindungsgemäßen Zellüberwachungseinheit mit erhöhter Robustheit gegenüber negativen Eingangsspannungen, wobei stellvertretend nur ein Spannungserfassungskanal dargestellt wird, nach einer ersten Ausführungsform,
Figur 5 eine Darstellung einer Anordnung von Schmelzsicherungen für mehrere Spannungserfassungskanäle einer erfindungsgemäßen Zellüberwachungseinheit mit erhöhter Robustheit gegenüber negativen Eingangsspannungen, nach einer zweiten Ausführungsform,
Figur 6 eine erfindungsgemäße Zellüberwachungseinheit mit erhöhter Robustheit gegenüber negativen Eingangsspannungen, nach einer dritten Ausführungsform, und
Figur 7 eine Senseleitungen aufweisende erfindungsgemäße Zellüberwachungseinheit mit erhöhter Robustheit gegenüber negativen Eingangsspannungen, nach einer vierten Ausführungsform.

### Ausführungsformen der Erfindung

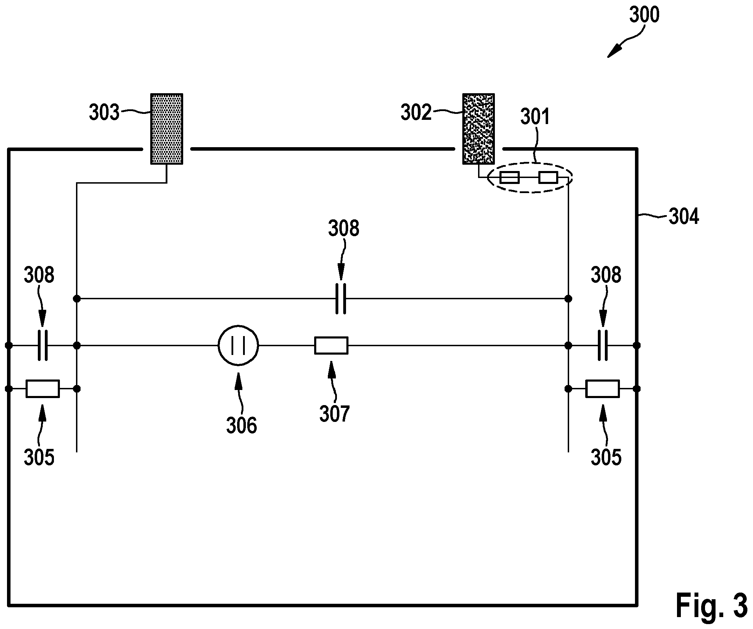

Häufig werden Batteriezellen für Traktionsbatterien mit integrierten Elementen zur Erhöhung der Sicherheit ausgeführt. Ein solches Element kann zum Beispiel eine in die Batteriezelle integrierte Sicherung sein. Siehe hierzu Figur 3, in der eine mit einer integrierten Sicherung 301 ("current interruptive device") versehene Batteriezelle 300 gezeigt wird, wobei die dort gezeigte Batteriezelle 300 die mit dem erfindungsgemäßen Batteriemanagementsystem (in Figur 3 nicht gezeigt) überwacht und geregelt werden kann. Werden Batteriesysteme, bei denen solche Batteriezellen 300 verwendet werden, mit unzulässig hohen Strömen betrieben, können die Sicherungselemente, hier die integrierte Sicherung 301, der Batteriezellen 300 auslösen, um eine Schädigung der Batteriezellen 300 zu verhindern. In diesem Fall können an den den betroffenen Batteriezellen 300 zugehörigen Eingangsklemmen des Batteriemanagementsystems sehr hohe negative Spannungen anliegen, die dem Betrage nach fast so hoch wie die gesamte Batteriespannung sein können, welche bei Traktionsbatterien bis zu 400 V oder mehr betragen kann.

In Figur 3 ist auch das Gehäuse 304 der Batteriezelle 300 gezeigt. Zwischen dem Gehäuse 304 und den Batteriezellenterminals 302, 303 existiert jeweils ein endlicher elektrischer Widerstand, dessen Wert in der Praxis von der besonderen Form der Batteriezelle 300 abhängt. Die Batteriezelle 300 hat außerdem einen bestimmten Innenwiderstand 307 und eine von der Zellenart und vom Ladezustand abhängige Leerlaufspannung 306, die bei Lithium-Ionen-Zellen typischerweise in einem Bereich zwischen 2,6 V bis 4,2 V gehalten wird. Gemäß der Ausführungsform in Figur 3 ist die integrierte Sicherung 301 mit einem positiven Batteriezellenterminal 302 verbunden und dazu vorgesehen, den Strompfad der Batteriezelle 300 zu unterbrechen. In der Figur 3 werden ferner die in der Batterie vorkommenden Kapazitäten 308 angedeutet.

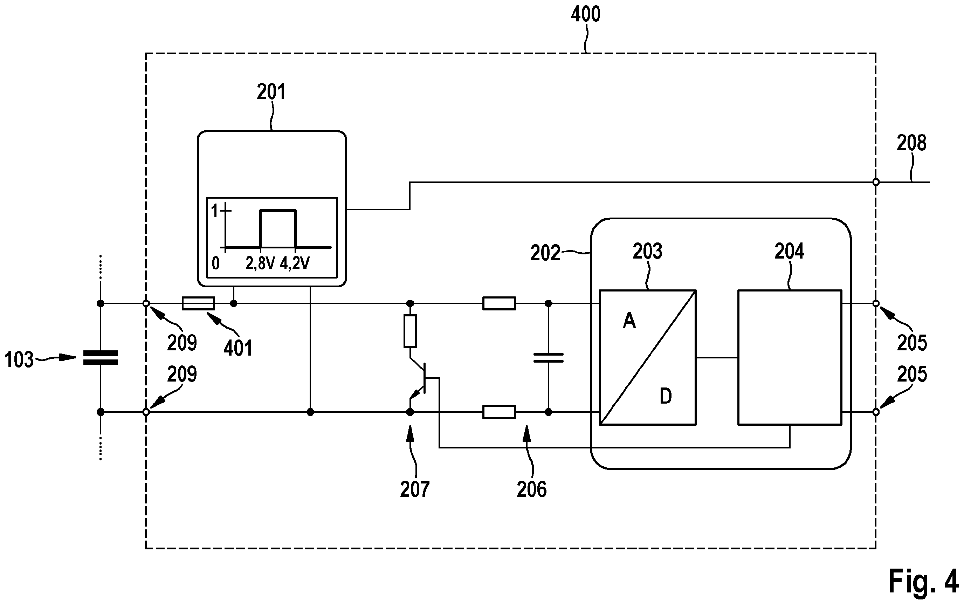

Figur 4 zeigt eine Darstellung einer erfindungsgemäßen Zellüberwachungseinheit mit erhöhter Robustheit gegenüber negativen Eingangsspannungen nach einer Ausführungsform der Erfindung. Der Einfachheit halber wird in der Figur 4 lediglich ein Spannungserfassungskanal gezeigt. Jedoch weist die Zellüberwachungseinheit 400 im Allgemeinen eine Vielzahl von Spannungserfassungskanälen auf.

Die in Figur 4 gezeigten Komponenten, die bereits weiter oben im Zusammenhang mit der Figur 2 erläutert wurden, werden, um Wiederholungen zu vermeiden, hier nicht erneut diskutiert. In Figur 4 wird gezeigt, wie die Zellüberwachungselektronik des erfindungsgemäßen Batteriemanagementsystems über eine einfache Schmelzsicherung 401 vor den Auswirkungen unzulässiger negativer Spannungen geschützt werden kann. Treten an einem oder mehreren Eingängen der Zellüberwachungs-Elektronik negative Eingangsspannungen auf, fließen in den integrierten Schaltungen der zur Spannungserfassung und -Überwachung eingesetzten Elektronikkomponenten üblicherweise unzulässig hohe Inversströme. Als Folge davon löst die in Figur 4 dargestellte Schmelzsicherung 401 aus und verhindert, dass hohe Ströme die Leiterbahnen so stark erwärmen können, dass das Platinenmaterial in Brand gerät. Somit kann mit der in Figur 4 gezeigten Anordnung die Robustheit insbesondere bei einem externen und auch bei einem batterieinternen Kurzschluss, wie er als Folge eines Unfalls mit mechanischer Deformierung der Batterie oder wegen anderer Gründe auftreten kann, deutlich erhöht werden.

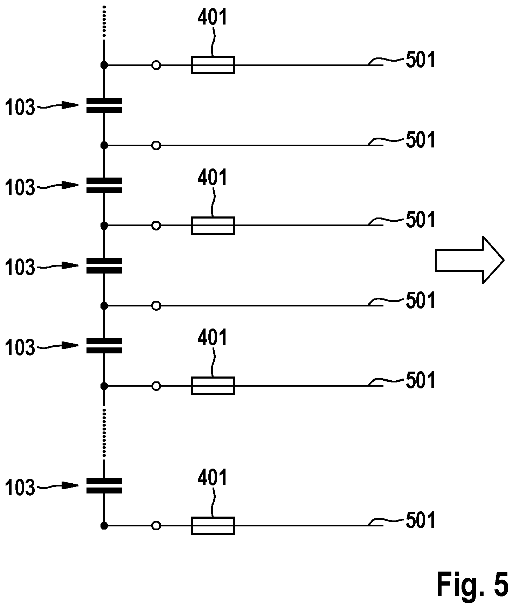

In Figur 5 wird beispielhaft eine Möglichkeit einer Anordnung von Zuführungsleitungen 501 und von Schmelzsicherungen für mehrere Spannungserfassungskanäle einer erfindungsgemäßen Zellüberwachungseinheit nach einer zweiten Ausführungsform der Erfindung gezeigt.

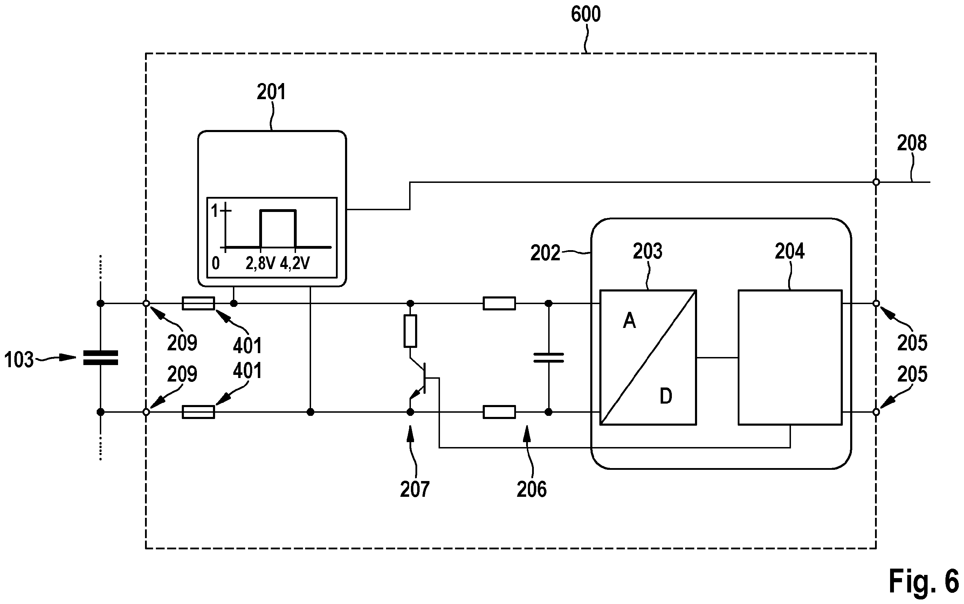

In Figur 6 wird eine erfindungsgemäße Zellüberwachungseinheit mit erhöhter Robustheit gegenüber negativen Eingangsspannungen nach einer dritten Ausführungsform der Erfindung gezeigt.

Im Unterschied zu der in Figur 4 gezeigten Zellüberwachungseinheit 400 ist in der in Figur 6 gezeigten Zellüberwachungseinheit in beiden Zweigen der Zuführungsleitungen beziehungsweise des Spannungserfassungskanals jeweils eine Schmelzsicherung 401 angeordnet.

Aufgrund der Lösung gemäß Figur 6 kann, zwar mit höheren Kosten wegen doppelt so vieler Sicherungen, ein sehr umfassender Schutz für alle Möglichkeiten einer negativen elektrischen Spannung, denen das Batteriemanagementsystem ausgesetzt sein kann, verwirklicht werden. Durch die erhöhte Anzahl von in den Zuführungsleitungen angeordneten Sicherungen 401 können selbst Fälle, in denen eine negative Spannung über zwei in direkter Nachbarschaft angeordnete Kanäle des Batteriemanagementsystems auftritt, abgesichert werden.

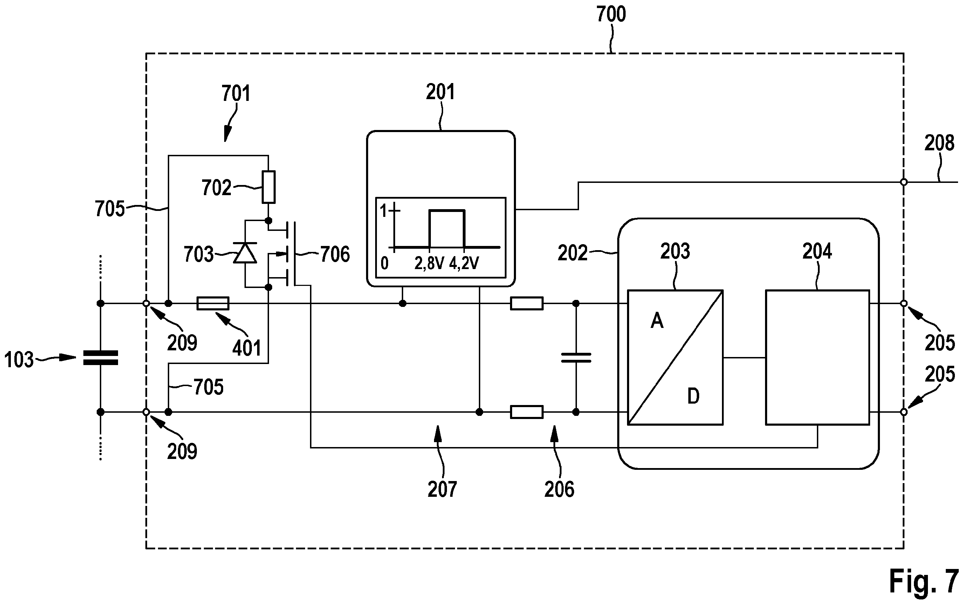

In Figur 7 wird eine sogenannte Senseleitungen aufweisende erfindungsgemäße Zellüberwachungseinheit mit erhöhter Robustheit gegenüber negativen Eingangsspannungen nach einer vierten Ausführungsform der Erfindung gezeigt.

Gemäß Figur 7 ist die erfindungsgemäße Schmelzsicherung hinter dem Schaltungsteil 701 für das Balancing der Zellen angeordnet. Dabei kann die Balancingschaltung 701 über eine geeignete Auslegung der für das Zellbalancing eingesetzten Komponenten geschützt werden. Der dargestellte MOSFET-Schalter 706 besitzt eine Intrinsic-Diode 703, die invers zu der normalen Zellspannung gepolt ist. Liegt als Folge eines Kurzschlusses eine negative Spannung am Eingang der Zellüberwachungseinheit 700 an, wird die Intrinsic-Diode 703 leitend und es fließt ein Strom, welcher über den Balancingwiderstand 702 begrenzt wird. Bei geeigneter Auslegung des Balancingwiderstands 702 kann der Strom so begrenzt werden, dass kein Brand des Leiterplattenmaterials entstehen kann.

Bei der Zellüberwachungseinheit 700 werden die Senseleitungen 704 für eine hochgenaue Erfassung der Zellspannungen eingesetzt. Hierzu werden die für das Balancing der Zellen eingesetzten Schaltungsteile 701 direkt an den Anschlüssen 209 auf der Leiterplatte mit getrennten Signalleitungen geführt, damit Spannungsabfälle als Folge der Balancingströme nicht zu einer Verfälschung der Spannungsermittlung der Batteriezellen 103 führen. Der Begleitchip 201 ist dazu vorgesehen, parallel und unabhängig von der Spannungsermittlung zusätzlich eine Spannungsüberwachung durchzuführen, bei der hier überprüft wird, ob die Zellspannungen sich innerhalb des aus Sicherheitsgründen eingeschränkten Spannungsintervalls befinden oder nicht. Gemäß der in Figur 7 gezeigten beispielhaften Ausführung ist der Begleitchip 201 parallel zu der Balancingschaltung 701 ebenfalls an die Senseleitungen 704 angebunden. Jedoch könnte der Begleitchip 201 stattdessen auch an den Leitungen 705 angeschlossen werden, über die das Balancing der Batteriezellen 103 durchgeführt wird. Dann müssten allerdings zum Schutz des Begleitchips 201 vor negativen Spannungen zusätzliche Sicherungsmaßnahmen getroffen werden, die mit zusätzlichem Schaltungsaufwand verbunden wären.

## Patentansprüche

1. Batteriemanagementsystem (100), aufweisend
- mindestens eine Zellüberwachungseinheit (400, 600, 700), umfassend- mehrere Zellspannungsanschlüsse (209),
- mit den Zellspannungsanschlüssen (209) gekoppelte Zuführungsleitungen (501), und
- eine Zellüberwachungsschaltung aus mehreren elektronischen
Halbleitermodulen, die mittels der Zuführungsleitungen (501) parallel geschaltet sind, wobei die mindestens eine Zellüberwachungseinheit (400, 600, 700) dazu ausgebildet ist, eine Vielzahl von Batteriezellen (103) zu überwachen, die jeweils beidseitig, mit ihrem jeweiligen positiven Batteriezellenterminal (302) und ihrem negativen Batteriezellenterminal (110) über die Zellspannungsanschlüsse (209) mit der Zellüberwachungseinheit (400, 600, 700) verbunden sind, und wobeieine oder mehrere der Zuführungsleitungen (501) mit einer Schmelzsicherung (401) versehen sind, wobei je Batteriezelle (103) zumindest eine der mit dieser gekoppelten Zufühungsleitung (501) eine Schmelzsicherung (401) in ihrem Strompfad aufweist, **dadurch gekennzeichnet, dass**
die Zuführungsleitungen (501) jeweils entweder einen positiven Zweig zum Kontaktieren mit einem positiven Batteriezellenterminal (302) oder einen negativen Zweig zum Kontaktieren mit einem negativen Batteriezellenterminal (303) bilden, wobei die Schmelzsicherungen (401) bezogen auf eine Reihenfolge, die durch eine Anordnung der Zellspannungsanschlüsse (209) in eine Richtung entlang eines Stranges aus Batteriezellen (103) gegeben ist, wechselweise in einem positiven Zweig oder einem negativen Zweig der Zuführungsleitungen (501) platziert sind.

2. Batteriemanagementsystem (100) nach Anspruch 1, wobei die elektronischen Halbleitermodule einen Begleitchip (201) zur Überwachung einer elektrischen Spannung einer überwachten Batteriezelle (103) und einen Hauptchip (202), der einen Analog-Digital-Wandler (203) und eine Steuerungs- und Kommunikationseinheit (204) aufweist, umfassen.

3. Batteriemanagementsystem (100) nach einem der vorhergehenden Ansprüche, wobei zumindest eine der Zellüberwachungseinheiten (400, 600, 700) derart ausgestaltet ist, dass ihre Zuführungsleitungen (501) als mit den entsprechenden zugeordneten Zellspannungsanschlüssen (209) gekoppelte Senseleitungen (704) ausgebildet sind und die elektronischen Halbleitermodule der zumindest einen Zellüberwachungseinheit (400, 600, 700) ferner zumindest eine Balancingschaltung (701) aufweisen, die direkt an die Zellspannungsanschlüsse (209) gekoppelt ist derart, dass die Balancingschaltung (701) zwischen den Zellspannungsanschlüssen (209) und den restlichen Halbleitermodulen, insbesondere einer Schaltung zur Ermittlung von Zellspannungen angeordnet ist.

4. Batteriemanagementsystem (100) nach Anspruch 3, wobei die Balancingschaltung (701) einen MOSFET-Schalter (706), einen Balancingwiderstand (702), und eine invers zu einer normalen Batteriezellenspannung gepolte Intrinsic-Diode (703) aufweist.

5. Batterie mit einem oder mehreren Batteriemodulen, die jeweils mehrere Batteriezellen (103) aufweisen, die in einem Batteriestrang in Reihe geschaltet sind, und mit einem Batteriemanagementsystem (100) nach einem der vorhergehenden Ansprüche.

6. Batterie nach Anspruch 5, wobei zum Schutz der Batteriezellen (103) vor Überstrom eine oder mehrere der in Reihe geschalteten Batteriezellen (103) jeweils eine integrierte Zellsicherung (301) aufweisen.

7. Batterie nach Anspruch 5 oder 6, wobei die Batteriezellen (103) Lithium-Ionen-Zellen sind.

8. Kraftfahrzeug mit einem Elektromotor und einer Batterie nach einem der Ansprüche 5 bis 7, die den Elektromotor versorgt und in einem Antriebsstrang des Kraftfahrzeugs angeordnet ist.

## Claims

1. Battery management system (100), having
- at least one cell monitoring unit (400, 600, 700) comprising a plurality of cell voltage connections (209),
- supply lines (501) coupled to the cell voltage connections (209), and
- a cell monitoring circuit composed of a plurality of electronic semiconductor modules which are connected in parallel by means of the supply lines (501), wherein the at least one cell monitoring unit (400, 600, 700) is designed to monitor a multiplicity of battery cells (103) which are in each case connected on both sides by means of their respective positive battery cell terminal (302) and their negative battery cell terminal (110) via the cell voltage connections (209) to the cell monitoring unit and wherein one or more of the supply lines (501) are provided with a fuse (401), wherein, for each battery cell (103), at least one of the supply lines (501) coupled to said battery cell (103) has a fuse (401) in the current path thereof, **characterized in that** the supply lines (501) form in each case either a positive branch for making contact with a positive battery cell terminal (302) or a negative branch for making contact with a negative battery cell terminal (303), wherein the fuses (401) are alternately placed in a positive branch or a negative branch of the supply lines (501) on the basis of a sequence which is given by an arrangement of the cell voltage connections (209) in a direction along a string composed of battery cells (103).

2. Battery management system (100) according to Claim 1, wherein the electronic semiconductor modules comprise a companion chip (201) for monitoring an electric voltage of a monitored battery cell (103) and a main chip (202) which has an analog-to-digital converter (203) and a control and communication unit (204).

3. Battery management system (100) according to either of the preceding claims, wherein at least one of the cell monitoring units (400, 600, 700) is configured such that the supply lines (501) thereof are designed as sensing lines (704) coupled to the corresponding assigned cell voltage connections (209) and the electronic semiconductor modules of the at least one cell monitoring unit (400, 600, 700) further have at least one balancing circuit (701) which is directly coupled to the cell voltage connections (209) such that the balancing circuited (701) is arranged between the cell voltage connections (209) and the remaining semiconductor modules, in particular a circuit for determining cell voltages.

4. Battery management system (100) according to Claim 3, wherein the balancing circuit (701) has a MOSFET switch (706), a balancing resistor (702), and an intrinsic diode (703), which is reverse-biased with respect to a normal battery cell voltage.

5. Battery having one or more battery modules which in each case have a plurality of battery cells (103) which are connected in series in a battery string, and having a battery management system (100) according to one of the preceding claims.

6. Battery according to Claim 5, wherein one or more of the series-connected battery cells (103) have in each case an integrated cell fuse (301) to protect the battery cells (103) against overcurrent.

7. Battery according to Claim 5 or 6, wherein the battery cells (103) are lithium-ion cells.

8. Motor vehicle having an electric motor and a battery according to any of Claims 5 to 7, which battery supplies the electric motor and is arranged in a drive train of the motor vehicle.

## Revendications

1. Système de gestion de batterie (100), possédant
- au moins une unité de surveillance de cellule (400, 600, 700), comprenant plusieurs raccords de tension de cellule (209),
- des lignes d'arrivée (501) connectées aux raccords de tension de cellule (209), et
- un circuit de surveillance de cellule constitué de plusieurs modules semiconducteurs électroniques, lesquels sont branchés en parallèle au moyen des lignes d'arrivée (501), l'au moins une unité de surveillance de cellule (400, 600, 700) étant configurée pour surveiller une pluralité de cellules de batterie (103), lesquelles sont respectivement reliées des deux côtés, à chaque fois par leur borne de cellule de batterie positive (302) et leur borne de cellule de batterie négative (110), à l'unité de surveillance de cellule (400, 600, 700) par le biais des raccords de tension de cellule (209), et une ou plusieurs des lignes d'arrivée (501) étant pourvues d'un fusible (401), pour chaque cellule de batterie (103), au moins une des ligne d'arrivée (501) connectée à celle-ci possédant un fusible (401) dans son trajet de courant, **caractérisé en ce que**
les lignes d'arrivée (501) forment respectivement soit une branche positive destinée à venir en contact avec une borne de cellule de batterie positive (302), soit une branche négative destinée à venir en contact avec une borne de cellule de batterie négative (303), les fusibles (401) étant placés en alternance dans une branche positive ou une branche négative des lignes d'arrivée (501), en rapport avec une séquence qui est donnée par un arrangement des raccords de tension de cellule (209) dans une direction le long d'une ligne composée de cellules de batterie (103).

2. Système de gestion de batterie (100) selon la revendication 1, les modules semiconducteurs électroniques comprenant une puce auxiliaire (201) destinée à surveiller une tension électrique d'une cellule de batterie (103) surveillée et une puce principale (202) qui possède un convertisseur analogique/numérique (203) et une unité de commande et de communication (204).

3. Système de gestion de batterie (100) selon l'une des revendications précédentes, au moins l'une des unités de surveillance de cellule (400, 600, 700) étant configurée de telle sorte que ses lignes d'arrivée (501) sont configurées sous la forme de lignes de détection (704) connectées aux raccords de tension de cellule (209) associés correspondants et les modules semiconducteurs électroniques de l'au moins une unité de surveillance de cellule (400, 600, 700) possèdent en outre au moins un circuit d'équilibrage (701) qui est connecté directement aux raccords de tension de cellule (209) de telle sorte que le circuit d'équilibrage (701) est disposé entre les raccords de tension de cellule (209) et le reste des modules semiconducteurs, notamment un circuit destiné à déterminer des tensions de cellule.

4. Système de gestion de batterie (100) selon la revendication 3, le circuit d'équilibrage (701) possédant un commutateur à MOSFET (706), une résistance d'équilibrage (702) et une diode intrinsèque (703) polarisée à l'inverse d'une tension de cellule de batterie normale.

5. Batterie comprenant un ou plusieurs modules de batterie, lesquels possèdent respectivement plusieurs cellules de batterie (103) qui sont branchées en série en une ligne de batteries, et comprenent un système de gestion de batterie (100) selon l'une des revendications précédentes.

6. Batterie selon la revendication 5, une ou plusieurs cellules de batterie (103) branchées en série possédant respectivement un fusible de cellule (301) intégré pour la protection des cellules de batterie (103) contre les surintensités.

7. Batterie selon la revendication 5 ou 6, les cellules de batterie (103) étant des cellules aux ions de lithium.

8. Véhicule automobile équipé d'un moteur électrique et d'une batterie selon l'une des revendications 5 à 7, laquelle alimente le moteur électrique et est disposée dans une chaîne cinématique du véhicule automobile.
